# EUROPÄISCHE PATENTSCHRIFT

(11) **EP 3 493 920 B1**
(45) Veröffentlichungstag und Bekanntmachung des Hinweises auf die Patenterteilung: **22.03.2023**
(21) Anmeldenummer: 17755083.7
(22) Anmeldetag: 04.08.2017
(51) Int. Cl.: H01F 5/06, H01F 41/12, B05D 1/00

(54) **PASSIVES ELEKTRISCHES BAUTEIL MIT BESCHICHTUNG ZUR VERBESSERUNG DER BELASTBARKEIT**
PASSIVE ELECTRICAL COMPONENT WITH COATING TO IMPROVE THE LOADING CAPACITY
PIÈCE ÉLECTRIQUE PASSIVE PRÉSENTANT UN REVÊTEMENT POUR AMÉLIORER LA CAPACITÉ DE CHARGE

(30) Priorität: 04.08.2016 DE 102016214493
(43) Veröffentlichungstag der Anmeldung: 12.06.2019
(73) Patentinhaber: Fraunhofer-Gesellschaft zur Förderung der angewandten Forschung e.V., 80686 München (DE)
(72) Erfinder: SALZ, Dirk, 28359 Bremen (DE); WILKEN, Ralph, 28359 Bremen (DE); DIECKHOFF, Stefan, 28359 Bremen (DE); BURCHARDT, Malte, 28325 Bremen (DE); DÖLLE, Christopher, 28359 Bremen (DE); REGULA, Christoph, 28359 Bremen (DE); WÖSTMANN, Franz-Josef, 28359 Bremen (DE)
(74) Vertreter: Eisenführ Speiser
(86) Internationale Anmeldenummer: PCT/EP2017/069782
(87) Internationale Veröffentlichungsnummer: WO 2018/024879

(56) Entgegenhaltungen:
- DE-A1-102011 005 234
- UWE LOMMATZSCH ET AL: "Plasma Polymerization of HMDSO with an Atmospheric Pressure Plasma Jet for Corrosion Protection of Aluminum and Low-Adhesion Surfaces", PLASMA PROCESSES AND POLYMERS, Bd. 6, Nr. 10, 14. Oktober 2009 (2009-10-14), Seiten 642-648, XP055006365, ISSN: 1612-8850, DOI: 10.1002/ppap.200900032

## Beschreibung

Die Erfindung betrifft ein passives elektrisches Bauteil, insbesondere eine Spule, mit einer Zwischenschicht, wobei die Zwischenschicht einen geringeren Wärmeausdehnungskoeffizienten als die Oberfläche des elektrischen Bauteils, die mit der Zwischenschicht bedeckt ist, besitzt, und darauf angeordnet eine plasmapolymere, kohlenstoffhaltige Beschichtung.

Die Erfindung betrifft ferner die Verwendung einer entsprechenden plasmapolymeren Beschichtung zur Verbesserung der thermischen und/oder mechanischen Belastbarkeit und/oder der medialen Beständigkeit einer Zwischenschicht auf einem passiven elektrischen Bauteil, insbesondere durch die Verhinderung des Entstehens von durchgehenden Mikrorissen.

Außerdem betrifft die Erfindung ein Verfahren zur Herstellung eines passiven elektrischen Bauteils mit einer Zwischenschicht und einer darauf angeordneten plasmapolymeren Beschichtung - bevorzugt besitzen beide Schichten elektrisch isolierende Wirkung.

Aktuelle Trends in der Elektroindustrie gehen dahin, die Schichtdicken für elektrische Isolationsschichten bzw. -beschichtungen immer weiter zu reduzieren. Gründe hierfür sind neben der Möglichkeit zur effizienteren Bauraumausnutzung auch die Verringerung des Wärmewiderstands durch die geringeren Schichtdicken und die daraus resultierende Verbesserung beim Erwärmungs- bzw. Entwärmungsverhalten. Hier stellen die Inhaltsstoffe der Beschichtung bzw. bei größeren Schichtdicken die Ummantelungen eine Begrenzung im Sinne der dauerhaft nutzbaren Temperaturbereiche im Einsatz dar. So ermöglichen die gängigen, oft organisch basierten Beschichtungen aus Kupferdrahtlack oder Silikonummantelungen einen Einsatz bis ca. 200 °C bzw. ca. 230 °C. Kurzzeitige Überschreitungen (Schock) dieser Maximalwerte sind zwar teilweise möglich, führen aber bei längerem Einsatz zu einer meist dauerhaften thermischen Schädigung des Isolationsmaterials und damit zu einer signifikanten Reduzierung der Isolationseigenschaften und deutlichen Steigerung des Ausfallrisikos. Weiterhin besteht bei konventionellen Lacken das Risiko der lokalen Schichtdickenreduktion bei Erwärmung in Kombination mit mechanischem Druck auf das elektrische Bauteil durch die Einbausituation. Diese Schichtdickenreduktion führt an den auftretenden Stellen zur Reduktion der Isolationsfähigkeit und erhöht ebenfalls das Ausfallrisiko.

Nachteilig wirken sich zudem in den meisten Fällen die notwendigen Dicken der Schutzbeschichtung aus, die regelmäßig mehr als 0,1 mm betragen. Dies gilt insbesondere für die thermische Erwärmung (schlechter Wärmetransport) wie auch die maximal mögliche Bauraumausnutzung. Weiterhin erreichen viele Beschichtungsstoffe erst mit erhöhten Schichtdicken die geforderten Durchschlagsfestigkeiten gegen elektrische Spannungen (inklusive Sicherheitsaufschlag, typische Anforderungen nach VDE: (Einsatzsspannung + 1000V)*2).

Im Folgenden werden die wichtigsten bzw. gängigsten Isolationsstoffe kurz zusammengefasst:
- Ummantelung der Drähte mit Silikon (teilweise mit Glasfasergewebe): Einsatz meist bis 200 °C - Schock bis 230 °C, Spannungswerte bis 700 V - Spitzenspannungsprüfung bis 2,5 kV (Dickenabhängigkeit der Seele) bei ca. 1,5 mm Isolationsschichtdicke (3,5 V/µm)
- Kupferdrahtlack-Isolation - Basis: Polyesterimid - "Drahtlacke sind Lösungen von Polymeren in meist kresolischen Lösemittelgemischen. Alle Drahtlacke werden auf speziellen Drahtlackiermaschinen lackiert und bei 300 - 600 °C eingebrannt. Dabei werden die Lösemittel verdampft und katalytisch verbrannt. Die Wärme wird zum Beheizen der Anlage benutzt. Die Polymere vernetzen und es bilden sich unlösliche Filme. Beim Löten von - auch bereits mit einer Klinge oder Schmirgelpapier abisoliertem - Kupferlackdraht können geringe Mengen hochgiftiges Toluol-2,4-diisocyanat freigesetzt werden, daher ist an gewerblichen Arbeitsplätzen eine Absauganlage erforderlich. Um glatte, konzentrische und porenfreie Filme zu erhalten, werden Lackdrähte üblicherweise zwischen 6 und 20 Mal lackiert und eingebrannt. Als Faustregel gilt, dass der Lackfilm ca. 10 % des Gewichtes des Kupferlackdrahtes ausmacht. Der dadurch steigende Durchmesser wird als Zunahme bezeichnet." - Quelle ist: https://de.wikipedia.org/wiki/Kupferlackdraht
- Polyesterimid - Siehe auch Kapton (kurzzeitig für Belastungen bis ca. 400 °C, sonst max. ca. 250 °C) neben weiteren verschieden modifizierten Polyimiden. Die Folien haben eine Durchschlagsfestigkeit im Bereich von 180 V/µm - Foliendicke ist typischerweise ~0,1 mm. Folien sind aber aufgrund ihrer relativen Starre und im Falle von hohen Biegeradien wegen einer begrenzten Rissdehnung für viele 3-D-Geometrien nicht geeignet.
- Feinqlimmer:
   z. B. K-Therm AS-M 600 / 800: Bis 800 °C kurzzeitig und 700 °C dauerhaft Durchschlagsfestigkeit ca. 20 kV/mm (20 V/µm) - Nachteile sind große produktionstechnische Schichtdicken von 0,5 - 75 mm - Aufbau aus mit Silikonharz imprägniertem Glimmerpapier unter hohem Druck und Temperatur hergestellte→ Es sind somit Hochtemperaturschichtpressstoffe mit vergleichsweise hoher Schichtdicke.
- Polyaryletherketone (PAEK):
   "Polyetherketone (kurz PEK) sind Polymere, in deren molekularen Rückgrat abwechselnd Keton- und Etherfunktionalitäten vorkommen. Am gebräuchlichsten sind Polyaryletherketone (PAEK), bei denen sich zwischen den funktionellen Gruppen jeweils eine in (1,4)-Position verknüpfte Arylgruppe befindet". Sie sind beständig gegen viele Chemikalien und bis ca. 250 °C und bis ~ 20 kV/mm (20 V/µm) Durchschlagsfestigkeit dauerhaft einsetzbar. Für ausreichende Isolationswerte wird aber eine hohe Schichtdicke benötigt.
- Keramische Beschichtungen:
   ∘ Wasser-Plasma-Technik zum Aufbringen von keramischen Schutzschichten (0,1 - 5 mm Dicke): Durchschlagsfestigkeit bis ca. 3 - 4 kV/mm (3 - 4 V/µm) bei Temperaturen bis max. 1400 °C je nach Keramik - aber sehr spröde und schwierig auf komplexe Geometrien zu applizieren, besonders wenn diese zum Beschichtungsvorgang gedehnt (notwendige Spaltgängigkeit) und danach in Einbau gestaucht werden müssen.
   ∘ Abweichend zu Beschichtungen - Vergussmassen: Möglichkeit zum Verguss mit keramikgefüllten Vergussmassen - teilweise temperaturstabil bis > 1000 °C - relativ gute Spaltgängigkeit bei genügend kleinen Füllstoffpartikeln - In der Applizierung von größeren Schichtdicken (> 100 - 150 µm) einsetzbar.
- Keramische Textilien (schlauchartige Überzüge):
   Polykristalline Metalloxidfasern verarbeitet zu einem Gewebe - Filamentdurchmesser ~10 - 12 µm, Hitzebeständig bis ca. 1200 °C mit Durchschlagsfestigkeiten bis zu 35 kV/mm, als Gewebelage verwendbar, aber mit hohen Dicken (0,5 - 1,2 mm) und nur zur Umwicklung geeignet - dadurch begrenzt für 3D-Geometrien einsetzbar.

Die DE 10131156 A1 beschreibt eine polymere Plasmabeschichtung mit einem Kohlenstoffgehalt von 25 bis 50 Atom-% und gibt, allerdings nur sehr allgemein, eine mögliche Zwischenschicht zwischen einem Substrat und der polymere Plasmabeschichtung an. Das Substrat betrifft jedoch kein passives elektrisches Bauteil und die DE 10131156 A1 schweigt sich zur Natur einer angeblich möglichen Zwischenschicht aus. Die EP 1260606 A2 beschreibt einen Werkstoff mit niedriger Dielektrizitätskonstante und ein CVD-Verfahren, betrifft aber ebenfalls kein passives elektrisches Bauteil.

Die DE 10 2014 224798 A1 beschreibt die Kontakteinheit einer elektromagnetischen Schaltvorrichtung mit einer dielektrischen mittels Plasmabeschichtungsverfahren erzeugten Deckschicht, die als Bauteil für elektromechanische Schaltvorrichtungen, insbesondere Leistungsschaltvorrichtungen und ggf. Leitungsschalter oder Fehlerstromschutzschalter dienen sollen, um insbesondere die Kriechstromfestigkeit und verbesserte mechanische Gleiteigenschaften bereitzustellen. Es wird lediglich sehr allgemein erwähnt, dass zwischen Schaltvorrichtung und Deckschicht noch eine oder mehrere Funktionsschichten denkbar sind, jedoch ohne nähere Angaben zu den Funktionsschichten.

Die DE 10 2013 110394 A1 offenbart Vorrichtungen mit einer spannungsfesten, elektrisch isolierende mehrlagigen Beschichtung, wobei eine Zwischenschicht ("untere Schicht") vorliegt, die eine Lage aus DLC (diamond-like carbon) bzw. eine Lage aus Al2O3, SiOx, SiNₓ, TazOs, HfOz, TiOz oder ZrOz enthalten kann, und umfasst elektrische Bauteile wie Schichtkondensatoren.

Eine Dehnbarkeit der Beschichtung ist nicht beschrieben.

Die DE 19608158 C1 beschreibt einen technologischen Hintergrund für Plasmabeschichtungen.

Vor dem Hintergrund des beschriebenen Standes der Technik war es Aufgabe der vorliegenden Erfindung, ein passives elektrisches Bauteil anzugeben, das mit einem Schichtsystem geschützt ist, das eine Vielzahl der oben beschriebenen Nachteile überwindet. Insbesondere war es gewünscht, dass das Schichtsystem übliche Passivierungen von Oberflächen elektrischer Bauteile mit einbezieht, verhältnismäßig kostengünstig ist, eine gute Wärmeleitfähigkeit gewährleisten kann, auch bei verhältnismäßig hohen Temperaturen noch immer über eine gute Durchschlagsfestigkeit verfügt und/oder einen guten Schutz gegen mechanische, chemische und/oder physikalische Belastungen darstellt. Ferner sollte das passive elektrische Bauteil bevorzugt in Bezug auf sein Schichtsystem flexibel bleiben, sodass gewisse Verformungen nach Aufbringen des Schichtsystems möglich sind, ohne dass es zu Einbußen in den gewünschten Wirkungen kommt.

Gelöst wird diese Aufgabe durch ein passives elektrisches Bauteil, insbesondere eine Spule, mit einer Zwischenschicht, wobei die Zwischenschicht einen geringeren Wärmeausdehnungskoeffizienten als die Oberfläche des elektrischen Bauteils, die mit der Zwischenschicht bedeckt ist, besitzt, und darauf angeordnet eine plasmapolymere, kohlenstoffhaltige Beschichtung mit einem Kohlenstoffanteil gemessen in einer Tiefe von 80 nm entfernt von der von der Zwischenschicht abgewandten Seite der plasmapolymeren Beschichtung, wobei die plasmapolymere Beschichtung einen Kohlenstoffanteil von 50 bis 100 Atom-%, vorzugsweise 50 bis 90 Atom-% umfasst oder als metallorganische Beschichtung einen Kohlenstoffanteil von 2 bis 50 Atom-% ausgestaltet ist, jeweils gemessen mittels XPS und bezogen auf die Gesamtzahl der mit XPS-erfassten Atome; und wobei die plasmapolymere Schicht eine Dicke von 100 nm bis 100 µm besitzt.

Grundsätzlich ist es bekannt, passive elektrische Bauteile mit Schichten, die über einen geringeren Wärmeausdehnungskoeffizienten verfügen als die beschichtete Oberfläche, elektrisch zu isolieren bzw. gegen eine Reihe von Einflüssen zu schützen. Allerdings geht aufgrund der unterschiedlichen Wärmeausdehnungskoeffizienten im Falle von mechanischen und/oder thermischen Belastungen häufig ein Teil der Schutzwirkung der bedeckten Schicht verloren. Typisch für solche Schichten sind beispielsweise Eloxalschichten oder keramische Schichten.

Überraschenderweise hat sich herausgestellt, dass in der Kombination mit der beschriebenen plasmapolymeren, kohlenstoffhaltigen Beschichtung die Möglichkeit eröffnet wurde, passive elektrische Bauteile mit verbesserter Belastbarkeit bereitzustellen, als durch die Kombination (additiv) der Zwischenschicht mit der (zusätzlichen) plasmapolymeren Beschichtung zu erwarten wäre.

Die Erzeugung plasmapolymerer Beschichtungen beziehungsweise die Plasmapolymerisation an sich sind dem Fachmann bekannt. Die Plasmapolymerisation ist eine spezielle plasma unterstützte Variante der chemischen Gasphasenabscheidung (PE-CVD). Bei der Plasmapolymerisation werden dampfförmige organische Vorläuferverbindungen (Precursor-Monomere) in der Prozesskammer durch ein Plasma zunächst aktiviert. Durch die Aktivierung entstehen ionisierte Moleküle, angeregte Zustände oder Radikale und es bilden sich in der Gasphase zum Teil Molekülfragmente der Precursoren. Die anschließende Kondensation dieser Fragmente auf der Substratoberfläche bewirkt dann unter Einwirkung von Substrattemperatur, Elektronen- und lonenbeschuss die Polymerisation und somit die Bildung einer geschlossenen Schicht. Die Struktur der entstehenden Plasmapolymere ist stark vernetzt und sie bilden ein weitgehend statistisches kovalentes Netzwerk. Die Abscheidung von kettenförmigen Polymeren in ein- oder polykristalliner Form ist daher durch Plasmapolymerisation nicht möglich. Die eingesetzten Precursoren werden unter PE-CVD-Bedingungen erst durch die Anregung im Plasmaprozess in reaktive Spezies umgewandelt. Der Fachmann unterscheidet daher die Plasmapolymerisation von anderen Abscheidungsverfahren wie z.B. die Atomlagenabscheidung (ALD-Verfahren), Beim ALD-Verfahren handelt es sich um ein stark verändertes CVD-Verfahren durch zwei oder mehr zyklisch durchgeführte selbstbegrenzende Oberflächenreaktionen, wodurch die Schichten in der Regel eine polykristalline oder amorphe Struktur erhalten.

Die erfindungsgemäß bevorzugt verwendete Plasmapolymerisation ist eine spezielle plasmaaktivierte Variante der chemischen Gasphasenabscheidung (PE-CVD), insbesondere wie weiter unten näher beschrieben.

Ohne an eine Theorie gebunden zu sein, scheint die plasmapolymere, kohlenstoffhaltige Schicht in der Lage zu sein, das Entstehen von Mikrorissen effektiv in der Zwischenschicht zu verhindern oder wenigstens erheblich einzuschränken, sodass in einem erheblichen Umfang eine Leistungssteigerung im Falle von Belastungen der Schutzwirkungen des Schichtsystems auf dem passiven elektrischen Bauteil erreicht wird.

Die Messung des Kohlenstoffanteils in der plasmapolymeren Schicht erfolgt in einer Tiefe von 80 nm, um Oberflächeneffekte wie z. B. die Sättigung mit Sauerstoff, auszublenden. Die Messung erfolgt hierbei bevorzugt wie im Messbeispiel 1 beschrieben.

Das erfindungsgemäße Bauteil ist ein passives elektrisches Bauteil. "Passives Bauteil" bedeutet in diesem Zusammenhang, dass es Wicklungen enthält, insbesondere ist es eine Spule, ein Kondensator oder ein Widerstand. Besonders bevorzugt ist das Bauteil ein passives elektrisches Leistungsbauteil. Ein Leistungsbauteil ist dadurch gekennzeichnet, dass es eine Energieform in eine andere umwandelt, z. B. ein Transformator. Analog zum Einsatz in einem Transformator sind weitere mögliche Einsatzgebiete für eine solche Spule beispielsweise in Motoren, Generatoren oder als Drosselspule möglich.

Bevorzugte erfindungsgemäße passive elektrische Bauteile sind solche, bei denen die mit der Zwischenschicht bedeckten Oberfläche (und natürlich die dazugehörigen Teile des Substrates) stromdurchflossen sind oder dafür vorgesehen sind, von Strom durchflossen zu werden.

Besonders bevorzugte passive elektrische Bauteile im Sinne der vorliegenden Erfindung sind dabei eine Spule, ein Kondensator, ein Widerstand oder Draht.

Bevorzugt ist ein erfindungsgemäßes passives elektrisches Bauteil mit einer Zwischenschicht, wobei die Zwischenschicht ausgewählt ist aus der Gruppe der DLC-Schichten keramischen Schichten, bevorzugt auf Basis TiO₂, SiO₂, Al₂O₃, TiₓN_{y} oder BN, weiter bevorzugt eine Eloxalschicht.

Eloxalschichten und keramische Schichten sind typische Isolierungsschichten, die im Stand der Technik eingesetzt werden bzw. Schutzschichten. Sie verfügen über einen verhältnismäßig geringen Wärmeausdehnungskoeffizienten, sodass sie in der Kombination mit darunter liegenden Metallen bei thermischer und mechanischer Belastung häufig ihre Schutzwirkung verlieren. Dieser Effekt lässt sich bei dieser Art von Schichten überraschenderweise besonders gut durch die erfindungsgemäß einzusetzende plasmapolymere Schicht ausgleichen bzw. abmildern.

Eine besonders bevorzugte Zwischenschicht im Sinne der vorliegenden Erfindung ist eine Eloxalschicht, insbesondere bei einer damit beschichteten Aluminiumoberfläche des passiven elektrischen Bauteils. Bevorzugte Schichtdicken der Zwischenschicht sind 0,2 bis 30 µm, weiter bevorzugt 1 bis 20 µm und besonders 2 bis 10 µm.

Weiterhin kann es in vielen Fällen bevorzugt sein, insbesondere bei einer Zwischenschicht aus Eloxal, dass die Zwischenschicht so ausgeführt ist, dass im REM-Schnitt zumindest im oberen Bereich zur plasmapolymeren, kohlenstoffhaltigen Beschichtung, nur noch geschlossene Poren vorhanden sind. Weiter bevorzugt kann es sein, dass im Oberflächenbereich der Eloxalschicht ein teilkristalliner Zustand vorliegt. Im Falle der Eloxalschicht kann diese Ausführung z. B. durch eine Nachverdichtung in heißem Wasser erzielt werden.

Bevorzugt ist ein erfindungsgemäßes passives elektrisches Bauteil mit einer Zwischenschicht, wobei die Zwischenschicht ein vernetztes und/oder unvernetztes Öl und/oder vernetztes und/oder unvernetztes Silikonöl enthält und/oder zwischen der Zwischenschicht und der plasmapolymeren Schicht eine Zone aus vernetztem Öl und/oder vernetztem Silikonöl vorhanden ist.

Unter einem Öl versteht der Fachmann eine vom lateinischen Begriff "oleum" abgeleitete Sammelbezeichnung für wasserunlösliche, bei 20 °C flüssige, organische Verbindungen mit relativ niedrigem Dampfdruck, deren gemeinsames Merkmal nicht die übereinstimmende chemische Konstitution, sondern die ähnliche physikalische Konsistenz ist. Öle haben eine relativ hohe Viskosität, sie sind in fast allen organischen Lösemitteln löslich. Es können natürliche, pflanzliche oder tierische, gegebenenfalls modifizierte pflanzliche oder tierische Öle, Mineralöle (aus Erdöl gewonnen) sowie vollsynthetische Öle wie z.B. Silikonöle sein. Zu den Nicht-Silikonölen zählen insbesondere Halogenfreie, organische Flüssigkeiten, ausgewählt aus der Gruppe bestehend aus Kohlenwasserstoffen, Fettsäuren, Triglyceriden, Mineralölen und Polyethern.

Unter einem Silikonöl versteht der Fachmann solche synthetische Öle, in denen SiliciumAtome über Sauerstoff-Atome kettenartig oder netzartig verknüpft und die restlichen Valenzen des Siliciums durch Kohlenwasserstoff-Reste, meist Methyl-Gruppen, seltener Ethyl-Gruppen, Propyl-Gruppen, Phenyl-Gruppen u.a., abgesättigt sind. Alternativ können die restlichen Valenzen auch teilweise oder vollständig durch Halogenkohlenwasserstoff-Gruppen, insbesondere Fluorkohlenwasserstoff-Gruppen, wobei gegebenenfalls sämtliche Wasserstoffe durch Halogen, insbesondere Fluoratome ersetzt sind, abgesättigt sein. Bevorzugt besitzen entsprechende Silikonöle ein Molekulargewicht von > 600 g/mol.

Ein vernetztes Öl oder ein vernetztes Silikonöl ist in der Lage, die Verbindung zwischen plasmapolymerer Schicht und Zwischenschicht zu stabilisieren und beispielsweise Unebenheiten auf der Zwischenschicht auszugleichen oder Poren der Zwischenschicht aufzufüllen. Dabei erfolgt bevorzugt die Vernetzung im Rahmen des Plasmapolymerisationsprozesses, der so eingestellt werden kann, dass vor der Schichtabscheidung vernetzende Bedingungen bestehen. Die als unvernetzt bezeichneten Bereiche weisen im Sinne der Erfindung immer auch einen geringen Grad an vernetzten Bestandteilen auf, was dem Sinne nach einer Teilvernetzung gleich kommt. Darüber hinaus sind die Öle bzw. Silikonöle an der offenen Seite der Poren der Eloxalschicht tendenziell mehr vernetzt und bieten durch den dort vorliegenden Grad der Vernetzung auch eine gute Adhäsion zum Eloxalmaterial. An der Gegenseite (geschlossene Porenseite zum Substratmaterial) ist der Vernetzungsgrad tendenziell geringer und kann auch in der oben beschrieben Form des unvernetzten Öls vorliegen. Als Alternative oder zusätzlich zur Porenfüllung ist auch eine Verdichtung der Zwischenschicht möglich, beispielsweise eine Heißverdichtung bei 90 bis 100 Grad Celsius in deionisiertem Wasser für eine Stunde.

Bevorzugt ist es, dass - sofern noch Poren in der Zwischenschicht vorhanden sind, diese eine Größe von 1 bis 200 nm, bevorzugt 1 bis 100 nm und weiterbevorzugt 1 bis 30 nm besitzen, jeweils bezogen auf den größten Porendurchmesser in Sicht senkrecht zur Oberfläche der Zwischenschicht, gemessen mit einem Rasterelektronenmikroskop.

In vielen Fällen ist es jedoch bevorzugt, dass die Poren der Zwischenschicht verfüllt sind. Hierzu eignet sich beispielsweise wärmevernetzendes Silikon. Ganz besonders bevorzugt ein Material namens "HTA" (Hersteller: AZ Elektronics Materials GmbH, Wiesbaden). Als Alternative oder zusätzlich zur Porenfüllung ist auch eine Verdichtung der Zwischenschicht möglich, beispielsweise eine Heißverdichtung bei 90 bis 100 Grad Celsius für eine Stunde.

Bevorzugt im Sinne der Erfindung ist ein passives elektrisches Bauteil mit einer Zwischenschicht, wobei die plasmapolymere Beschichtung Silizium umfasst.

Es hat sich herausgestellt, dass insbesondere die Kombination von Silizium mit kohlenstoffhaltigen plasmapolymeren Beschichtungen einen besonders guten Effekt auf die Schutzwirkung elektrischer Bauteile besitzt.

Die erfindungsgemäß einzusetzende plasmapolymere Beschichtung besitzt eine mittlere Schichtdicke von 100 nm bis 100 µm, bevorzugt von 200 nm bis 50 µm und weiter bevorzugt von 500 nm bis 10 µm.

Es ist bevorzugt, die plasmapolymere Schicht so abzuscheiden, dass sich auf dem Substrat eine Biasspannung aufbaut. Dies gelingt am besten durch Schaltung des zu beschichtenden Substrates als Kathode. Dies bewirkt einen lonenbeschluss der entstehenden Beschichtung, sodass - ohne an eine Theorie gebunden zu sein - Schichten entstehen, die über eine gute Kombination der Eigenschaften Härte und Flexibilität, ausgedrückt durch Rissdehnung von ≥ 2,5 %, bevorzugt ≥ 3 % besitzen (Dehnung bis Riss).

Eine solche Flexibilität ist insbesondere wichtig für passive elektrische Bauteile, die nach ihrer Beschichtung noch einmal verformt werden müssen, wie es beispielsweise bei Spulen nach dem Beschichtungsprozess der Fall sein kann.

Besonders gute Schichteigenschaften erreicht man dabei bei Einstellung von Biasspannungen von 50 bis 300 Volt, bevorzugt 100 bis 200 Volt während des Abscheidungsprozesses gegen Masse (des Plasmagenerators).

Bevorzugt ist, dass die plasmapolymere Beschichtung über eine mittels Nanoidentation zu messende Härte im Bereich von 1,5 bis 6 GPa, bevorzugt 2,4 bis 5 GPa, weiter bevorzugt 3,1 bis 4 GPa verfügt.

Diese Nanoidentationshärte ist besonders bevorzugt in Kombination einer Rissdehnung von ≥ 2,5 % und weiter bevorzugt in einer Kombination mit einer Rissdehnung von ≥ 3,0 %. Damit sind auf dem passiven elektrischen Bauteil Schichten vorgesehen, die über eine besonders gute Kombination von Härte und Flexibilität verfügen.

Bevorzugt im Sinne der Erfindung ist ein passives elektrisches Bauteil mit einer Zwischenschicht, wobei die mit der Zwischenschicht bedeckte Oberfläche des Bauteils aus Kupfer, Aluminium oder einer Legierung umfassen Kupfer und/oder Aluminium besteht.

Solche Oberflächen lassen sich besonders durch das erfindungsgemäß einzusetzende Schichtsystem schützen.

Bevorzugt ist es, dass ein erfindungsgemäßes passives elektrisches Bauteil insbesondere die Zwischenschicht vor der Beschichtung mit der erfindungsgemäß einzusetzenden plasmapolymeren Schicht über einen Rauwert R_{A} ≤ 4 µm, bevorzugt R_{A} ≤ 2 µm und weiter bevorzugt R_{A} ≤ 1 µm verfügt.

Der R_{A} wird gemessen gemäß DIN EN ISO 4288: 1998-04.

Hierzu kann es bevorzugt sein, dass während der Herstellung einer erfindungsgemäßen Spule, also vor dem Beschichten mit der plasmapolymeren Schicht eine Reinigung beziehungsweise Glättung der Oberfläche der Zwischenschicht erfolgt. Dies kann zum einen geschehen durch bereits oben beschriebene Auffüllung der Proben der Zwischenschicht oder eine Verdichtung der Zwischenschicht. Alternative Verfahren sind Reinigung in einem Reinigungsbad (z. B. mittels Ultraschall bevorzugt unter Einsatz eines Reinigungsmittels), Plasmapolieren, elektrolytisches Polieren und/oder weitere Reinigungsverfahren, die geeignet für die jeweilige Zwischenschichtoberfläche sind.

Selbstverständlich kann es bevorzugt sein, auch die entsprechende Oberfläche des Substrates (des passiven elektrischen Bauteils) so vorzubehandeln, dass eine Glättung stattfindet.

Bevorzugt ist ein erfindungsgemäßes passives elektrisches Bauteil mit einer Zwischenschicht, wobei die plasmapolymere Beschichtung durch Messung mittels XPS gemessen in einer Tiefe von 80 nm entfernt von der von der Zwischenschicht abgewandten Seite der plasmapolymeren Beschichtung bestimmbare Anteile umfasst, bevorzugt daraus besteht von 5 bis 40 Atom-%, bevorzugt 20 bis 32 Atom-% Silicium und/oder 30 bis 70 Atom-%, bevorzugt 40 bis 64 Atom-% Sauerstoff aufweist, bezogen auf die Gesamtzahl der in der Beschichtung enthaltenen Kohlenstoff-, Silicium- und Sauerstoffatome.

Die Schichten der bevorzugten atomaren Zusammensetzung haben sich als besonders geeignet für die Erfindung herausgestellt.

Bevorzugt ist ein erfindungsgemäßes passives elektrisches Bauteil mit einer Zwischenschicht, wobei die plasmapolymere Schicht über eine Abweichung von -60 % bis +1000 %, bevorzugt -50 % bis +500 %, weiter bevorzugt -55 % bis +250 % bezogen auf die mittlere Schichtdicke in einzelnen Bereichen der Schicht verfügt.

Es ist durch den Beschichtungsprozess möglich, dass beispielsweise bei der Beschichtung einer Aluminiumspule, die mit einer Eloxalzwischenschicht versehen ist, der Beschichtungsprozess so geführt wird, dass in der Mitte der Spule eine besonders geringe Schichtdicke der plasmapolymeren Schicht vorhanden ist, während außen die mittlere Schichtdicke vorhanden ist, während innen eine erhöhte Schichtdicke besteht. Die Innenseite ist die Seite der Spule, die zum Zahn des Motors bzw. Blechpaketes zeigt. Die Außenseite ist dem entsprechend die abgewandte Seite und die Mitte die Position dazwischen.

Bevorzugt ist ein erfindungsgemäßes passives elektrisches Bauteil mit einer erfindungsgemäß einzusetzenden Zwischenschicht, wobei die Zwischenschicht und die plasmapolymere Schicht gemeinsam eine Durchschlagsfestigkeit gemessen nach DIN EN 60243-1 und DIN EN 60243-2 von ≥ 100 V gemessen für einen Strom von bis zu maximal 3mA besitzt.

Die Durchschlagsfestigkeit ist eine wichtige Kenngröße für passive elektrische Bauteile, insbesondere für Spulen, Kondensatoren und Widerstände. Dabei hat sich herausgestellt, dass mit abnehmender Rauheit der mit der plasmapolymeren beschichteten Oberfläche bei ansonsten identischen Parametern (Schichtdicke, Abscheidungsbedingungen etc.) die elektrische Durchschlagsfestigkeit zunimmt.

Als bevorzugt zeigte sich auch, dass wenn die oben bezeichneten Rauwerte des Substrates überschritten werden, die Schichtdicke der Plasmapolymerschicht entsprechend einem Faktor zwischen 2 und 10 gesteigert werden muss, um dieselben elektrischen Isolationseigenschaften und Werte erzielen zu können.

Bevorzugt ist ein erfindungsgemäßes passives elektrisches Bauteil mit einer Zwischenschicht, wobei das Bauteil nach einer Auslagerung bei 300 °C für 500 Stunden in einem Umluftofen bei trockener Umluft und danach folgender Abkühlung auf 20 °C innerhalb einer Stunde wenigstens 80 % der Durchschlagsfestigkeit vor der Auslagerung besitzt.

In dem erfindungsgemäß einzusetzenden Beschichtungssystem auf dem passiven elektrischen Bauteil ist es möglich, überraschend gute und dauerhafte Werte für die Durchschlagsfestigkeit zu erzielen. Die Durchschlagsfestigkeit wird bevorzugt wie im Messbeispiel 2 beschrieben.

Es hat sich dabei herausgestellt, dass es auch möglich ist, erfindungsgemäße Bauteile, die plasmapolymer beschichtet sind, durch eine erneute entsprechende Beschichtung für Fälle zu reparieren, in denen die Bauteile nicht (mehr) die Mindestanforderungen erfüllen. Es ist sogar möglich, Bauteile, die nicht oder nicht mehr die Anforderungen z. B. an die Durchschlagsfestigkeit durch eine (Nach-) Beschichtung mit einer erfindungsgemäß einzusetzenden plasmapolymeren Schicht wieder herzustellen, auch wenn diese vorher nicht über eine solche Schicht verfügt haben.

Durch dieses Beschichten entsteht faktisch ein erfindungsgemäßes passives elektrisches Bauteil, und das Wiederherstellen und/oder Verbessern von Eigenschaften wie der Durchschlagsfestigkeit ist ein überraschender Effekt, der mittels der plasmapolymeren Beschichtung, insbesondere in den oben beschriebenen bevorzugten Varianten, erreicht werden kann.

Bevorzugt ist ein erfindungsgemäßes passives elektrisches Bauteil mit einer Zwischenschicht, wobei das elektrische Bauteil im Bereich der plasmapolymeren Schicht gegenüber einer 1 mol/l NaOH-Lösung für eine Dauer von 20 Minuten bei Raumtemperatur keinen optisch feststellbaren Ätzangriff aufweist.

Die Prüfung auf Beständigkeit gegenüber NaOH-Lösung ist im Messbeispiel 3 beschrieben.

Mit dem erfindungsgemäß einzusetzenden Schichtsystem aus Zwischenschicht und plasmapolymerer Deckschicht ist es möglich, passive elektrische Bauteile nicht nur elektrisch zu isolieren, sondern bei entsprechender Ausgestaltung ebenso gegen Korrosionsangriffe bzw. Ätzangriffe durch Laugen zu schützen.

Teil der Erfindung ist die Verwendung einer plasmapolymeren Beschichtung wie oben beschrieben, bevorzugt in einer der bevorzugten Varianten, zur Verbesserung der thermischen und/oder mechanischen Belastbarkeit und/oder der medialen Beständigkeit einer Zwischenschicht auf einem passiven elektrischen Bauteil jeweils wie oben definiert insbesondere durch Verhinderung des Entstehens durchgängiger Mikrorisse.

Unter "medialer" Beständigkeit ist insbesondere die Beständigkeit gegenüber oxydierenden Substanzen, insbesondere Sauerstoff und Wasser und/oder gegen Säuren und Basen, insbesondere gegenüber Basen im Sinne der vorliegenden Anmeldung zu verstehen. Im Zweifelsfall ist "mediale Beständigkeit" als Beständigkeit gegenüber 1M NaOH-Lösung zu bestimmen. Wie bereits oben beschrieben ist es ein Kern der vorliegenden Erfindung, dass durch die Kombination der Zwischenschicht, die gegenüber dem Substrat rissanfällig ist mit der plasmapolymeren Schicht eine deutliche Verbesserung der Schutzeigenschaften der Zwischenschicht erzielt werden kann.

Teil der Erfindung ist auch die Verwendung einer wie oben beschriebenen plasmapolymeren Beschichtung zur Wiederherstellung der Isolierwirkung einer wie oben beschriebenen Zwischenschicht auf einem passiven elektrischen Bauteil, insbesondere sowohl für die Zwischenschicht als auch für das passive elektrische Bauteil in einer der bevorzugten Varianten.

Somit ist es möglich, geschädigte passive elektrische Bauteile wieder herzustellen oder grundsätzlich für den Gebrauch vorzubereiten.

Teil der Erfindung ist auch ein Verfahren zum Herstellen eines passiven elektrischen Bauteils, wie oben beschrieben, mit einer Zwischenschicht und darauf angeordneten plasmapolymeren Beschichtung, umfassend die Schritte:
a) Bereitstellen eines passiven elektrischen Bauteils, wie oben beschrieben, als Substrat,
b) Anordnen einer Zwischenschicht wie oben beschrieben auf dem Substrat, bevorzugt mittels eines nasschemischen Verfahrens,
c) Abscheiden einer plasmapolymeren Beschichtung wie oben beschrieben auf der Zwischenschicht.

Mittels des erfindungsgemäßen Verfahrens ist es möglich, passive elektrische Bauteile mit den oben beschriebenen positiven Eigenschaften zu erzeugen.

Bevorzugt ist ein erfindungsgemäßes Verfahren, wobei im Schritt c) in einem Hochfrequenzplasmapolymerisationsreaktor unter Niederdruck durchgeführt wird und das Substrat als Kathode geschaltet ist.

Durch die Schaltung des Substrates als Kathode wird - wie oben bereits beschrieben - eine Beschleunigung von Ionen auf die plasmapolymere Beschichtung bewirkt. Hierdurch ist es möglich, dass durch den Impact der Ionen die Schicht sich intern so umgruppiert bzw. verändert, dass sie die überraschenden guten Schichteigenschaften in Kombination mit der erfindungsgemäß einzusetzenden Zwischenschicht erzeugt.

Die plasmapolymere Beschichtung kann allgemein sowohl aus siliziumorganischen (bevorzugt HMDSO) als auch aus rein organischen (bevorzugt Acetylen) Präkursoren hergestellt werden. Hierbei sind sowohl die Verwendung eines Präkursors zur Generierung eines anorganischen Gerüsts (bevorzugt siliziumbasiert) des Plasmapolymers als auch rein organische Präkursoren mit einer angepassten Netzwerkformation (in Richtung DLC-Schichten) möglich.

Die notwendigen Schichtdicken der Ausgestaltungsvarianten sind dabei im Wesentlichen an die mechanische Beständigkeit bzw. den Anforderungen an die Durchschlagsfestigkeit anzupassen. Zu berücksichtigen sind hierbei zudem ausreichende Toleranzen, um z.B. bestehende Oberflächendefekte im zu beschichtenden Material zu begegnen. Vorteilhaft kann dieses über sehr leicht über die Wahl der Schichtdicke erfolgen.

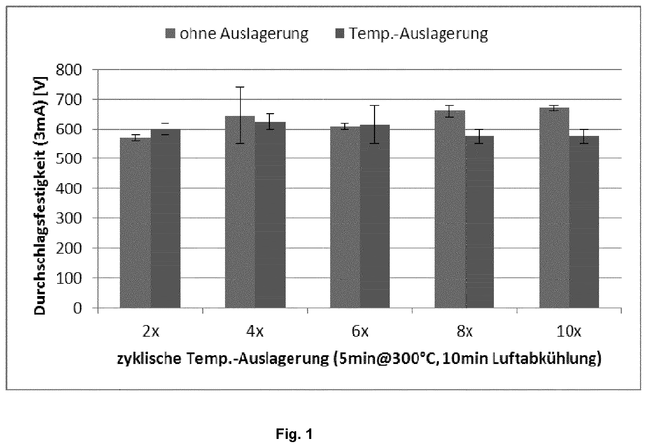

Die erfindungsgemäß einzusetzenden Schichten auf passiven elektrischen Bauteilen heben die Temperaturobergrenze für den Einsatz bevorzugt erfolgreich auf ≥ 300 °C. Ein experimentelles Beispiel hierfür lieferten die Daten, die der Fig. 1 zugrundeliegen:
Die Fig. 1 stellt die Ergebnisse zyklischer Auslagerungen unter hohen Temperaturen (5 min bei 300 °C) mit nachfolgender Abkühlung an der Luft für jeweils 10 Minuten dar. Als Beschichtung wurde die Schicht aus dem Ausführungsbeispiel 1 auf einer Aluminiumspule eingesetzt. Die Messungen wurden jeweils mit einer Spule vor und nach Auslagerung (linker und rechter Balken) durchgeführt. Eine Abweichung im Ausgangswert der Spulen für die jeweiligen Messpaare ist dadurch begründet, dass verschiedene Spulen eingesetzt wurden.

Die Schichtdicken betrugen dabei jeweils ca. 5 µm.

Die Durchschlagsfestigkeiten sind dabei abhängig von der applizierten Schichtkombination sowie der Schichtdicken der Schichtbestandteile und können auf über 2 kV gebracht (Schichtdicke ca. 60 µm ~33 V/µm) werden. Auch eine zyklische Aufheizung auf -180 °C für 10 Min inkl. direkter Abkühlung auf einem Metallblock (Ausgangstemperatur war Raumtemperatur) für 5 Min. zeigte keinen signifikanten Rückgang der Durchschlagsfestigkeit

Ebenso zeigte eine "extreme" Auslagerung der wie oben beschichteten Spulen einen ähnlichen Effekt:

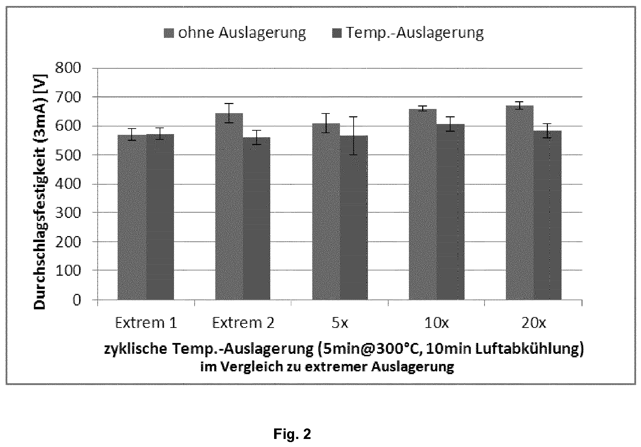

Die Fig. 2 stellt das Ergebnis einer 5-fach-zyklischen Auslagerung für 24 Stunden bei 180 °C und direkt danach eine Abkühlung auf -20 °C und Luftkontakt für eine Stunde mit einer erneuten Aufheizung auf 180 °C für eine Stunde und Abkühlung danach auf Raumtemparatur bei Luftkontakt (extrem 1 und extrem 2) im Vergleich mit einer zyklischen Auslagerung wie oben (5 Minuten bei 300 °C, 10 Minuten Luftabkühlung) für 5, 10 und 20 Zyklen (5x, 10x und 20x) dar. Dabei ist die linke Säule jeweils der Wert vor der jeweiligen Auslagerungsfolge, der Wert der rechten Säule ist der nach der jeweils beschriebenen Auslagerung.

### Beispiele

### Messbeispiele

### Messbeispiel 1

### Durchführung der XPS-Messung in 80 nm Schichttiefe

Eine Oberflächenanalyse mittels Photoelektronenspektroskopie (XPS) erfasst die äußersten ca. 10 nm einer Festkörperoberfläche. Um die chemische Zusammensetzung des Probenmaterials in einer Tiefe von 80 nm mit XPS analysieren zu können, wird die Oberfläche durch lonenstrahl-Beschuss abgetragen. Für diesen Zerstäubungsprozess werden üblicherweise Argon-Ionen mit einer Energie von 3 keV eingesetzt. Die Zeitdauer, die erforderlich ist, um die obersten 80 nm einer Probenoberfläche abzutragen, hängt von der gerätespezifischen Zerstäubungsrate ab. Diese wird jeweils durch Vergleichsmessungen an entsprechenden Referenzproben experimentell bestimmt. Der typische Druckbereich für derartige Sputterprozesse liegt im Bereich von 1*10^-5 bis 1*10^-6 mbar.

### Messbeispiel 2

### Prüfung der elektrischen Isolationseigenschaften:

### Teilentladungsmesstechnik:

*→ Zerstörungsfreie Prüfmethode* zur Bestimmung der elektrischen Isolationswirkung von Beschichtungen (Beispielhaft für das Gerät DWX-05 vorzugsweise an Spulengeometrien bzw. Elektromotoren)

### Technik:

Das verwendete Gerät (DWX-05) ist im Wesentlichen eine Hochspannungsquelle, die in der Lage ist, einen Hochspannungspuls in sehr kurzer Zeit (kürzer als 1 msek - mit sehr großer Flanke) zu generieren bzw. in das Bauteil "einzuprägen". Dabei wird das zu messende Bauteil (vorzugsweise eine Spule oder ein Motorenteil) zum Einen mit der Spannungsquelle und zum anderen mit der Messelektronik verbunden. Darüber hinaus ist am Gerät eine RF-Antenne (inkl. Bandfilter) angeschlossen, welche das Auftreten von RF-Entladungen (im zeitlichen Zusammenhang) mit dem eingeprägten Spannungspuls misst. Wichtig ist hierbei, dass sich die Antenne und die Spule nicht leitend berühren. Die Messung erfolgt nun ab einer voreingestellten Spannung und wird fortlaufend um einen bestimmten Wert gesteigert bis eine TE-Entladung festgestellt wird oder die erforderliche End-Spannung erreicht wird. Als Messung dient zum einen die Antwort des Systems (der Spule) selbst (Fall A) sowie zum Anderen die Detektion von RF-Entladungen (Fall B), welche charakteristisch sind und kurz vor dem Auftreten eines Überschlages zwischen zwei Windungen oder zum Zahn beobachtet werden. Die Messungen werden für jeden Spannungswert mind. 3-fach durchgeführt und aus den Endwerten wird ein Mittelwert ermittelt, um ein statistisch gesichertes Ergebnis zu erhalten. Bei großen Schwankungen der End-Messwerte, ist die Probe ggf. auf Homogenität zu kontrollieren bzw. der ermittelte Messwert nur mit Einschränkungen zu verwenden.

Die vorab erlaubten Abweichungen der Messsignale vom Sollzustand bilden damit sozusagen die Prüfkriterien ab. Maximal mögliche Spannungswerte am vorhandenen Gerät sind 5 kV.

Die Analyse der Messsignale erfolgt für diese Messmethode auf zwei Wegen (ggf. auch beide Kriterien gleichzeitig):
1. Abgleich mit einem Referenzsignal (Aufgenommen an einem unverletzten Bauteil bzw. in einem niedrigeren Spannungsbereich in dem die Isolierung definitiv intakt ist - Beurteilung aufgrund des Kurvenverlaufs) - Abweichungen von mehr als +20 % oder -4 % des detektierten Antwortsignals von der skalierten Kurve des Referenzsignals werden als "defekte" Isolierung für den jeweils geprüften Spannungswert angesehen bzw. ein Zusammenbruch des Antwortsignals (durch Kurzschluss)
   → Zusammengenommen Fall (A)
2. Messung der RF-Entladung und Abgleich mit dem "Grundrauschen" des RF-Signals - Bei Abweichungen bzw. dem Auftreten von deutlichen RF-Signalen (zeitlich korreliert mit dem Spannungsverlauf des eingeprägten Signals) wird ein Teilentladung detektiert und damit die Beschichtung als ab diesem Spannungswert für unzureichend bestimmt - Zusätzlich empfiehlt sich die Verwendung des LaPlace Kriterium 15/0 bei der automatisierten Auswertung.
   → Zusammengenommen Fall (B)

### Anforderung an Proben:

- Geometrie in Form einer Spule (Substrat Metall)
   ∘ Mind. Anforderung an Induktivität - aktuell mind. 10 Windungen, gerätespezifischer Wert
- Vollflächige Beschichtung in gleichbleibender Güte auf einem Bauteil bzw. der einzelnen Bauteile untereinander bei einer "Batchkontrolle"
- Zugänglichkeit der Kontaktierung sowie des Zahns (bei eingebautem Zustand) bzw. Bereiche an Zahn und Spule die ohne Beschichtung kontaktiert werden können.
   **→** Serientaugliche Prüfung für 100 % der Bauteile mit dieser Testmethode möglich

Weitere Informationen zu dieser Testmethode finden sich in: Ein neues Verfahren zur automatischen Gewinnung der Teilentladungseinsetz- und Aussetzspannung an elektrischen Wicklungen nach IEC TS 60034-18-41 und IEC TS 61934 - aus Konferenz: Internationaler ETG-Kongress 2009 - Fachtagung 3: Direktantriebe in Produktionsmaschinen und Industrieanlagen - Generatoren und Antriebe in regenerativen Kraftwerken / Fachtagung 4: Diagnostik elektrischer Betriebsmittel10/27/2009 - 10/28/2009 at Düsseldorf, Germany

### Messbeispiel 3

### Durchführung der Prüfung auf Beständigkeit gegenüber Natronlauge (mediale Beständigkeit)

Die Prüfung auf Beständigkeit gegenüber Natronlauge für bevorzugte erfindungsgemäße Ausgestaltungsvarianten wird wie folgt durchgeführt:
Die erfindungsgemäß ausgeführte Beschichtung wird für die Dauer von 20 Minuten mit 1mol/l NaOH-Lösung bei Raumtemperatur in Kontakt gebracht. Dies kann beispielsweise dadurch geschehen, dass man einen Tropfen der Natronlauge auf die Oberfläche gibt. Anschließend wird die Natronlauge-Lösung entfernt und so gereinigt, dass keine Reste auf der zu prüfenden Oberfläche verbleiben. Schließlich wird optisch, das heißt mit dem unbewaffneten Auge (ohne optische Hilfsmittel) geprüft, ob ein Ätzangriff stattgefunden hat. Ist die geprüfte Oberfläche unverändert, hat sie den Belastungstest bestanden.

### Messbeispiel 4

### Belastungstest für die Durchschlagsfestigkeit

Spulen / Proben wurden wie in Ausführungsbeispiel 1 hergestellt. Ein Ofen wurde auf 300 °C erwärmt und die Spulen darin platziert und für 500 Std. darin gelagert. Nach der Auslagerung wurden die Proben entnommen und innerhalb einer Std. auf Raumtemperatur abgekühlt. Danach wurden die Proben nach Messbeispiel 2 geprüft. Es wurde ein maximales Absinken der Durchschlags-Festigkeit um 15 % im Vergleich zum Ausgangszustand vor der Auslagerung beobachtet. Eine Variante nach Ausführungsbeispiel 2 erzielt ähnliche Werte wie die hier beschriebene Variante nach Ausführungsbeispiel 1.

### Messbeispiel 5

### Nanoidentationsmessung

Die Nanoindentierung ist eine Prüftechnik, mit der über eine feine Diamantspitze (dreiseitige Pyramide [Geometrie nach Berkovich], Radius wenige 100nm) die Härte von Oberflächenbeschichtungen ermittelt werden kann. Es wird hierbei entgegen der makroskopischen Härtebestimmung (wie z.B. Vickershärte) nicht die durch eine Normalkraft eingeprägte verbliebene Indentierungsmulde vermessen, sondern eine Eindringtiefe abhängige Querschnittsfläche des Nanoindentors angenommen. Diese tiefenabhängige Querschnittsfläche wird über eine Referenzprobe mit bekannter Härte ermittelt (i.d.R. hochreines Quarzglas).

Die Nanoindentierung verwendet während der Aufbringung der Normalkraft eine empfindliche Auslenkungssensorik (kapazitive Platten), mit der die Eindringtiefe bei steigender und wieder sinkender Normalkraft präzise gemessen werden kann - ganz anders als bei der klassischen Vorgehensweise - . Die Normalkraft-Eindringtiefe-Kurve gibt während der Anfangsphase der Entlastung insitu die Steifigkeit der Probe an. Mithilfe der von der Referenzprobe bekannten Querschnittsfläche des Nanoindentors kann so das Elastizitätsmodul und die Härte der Probe bestimmt werden. Die maximale Prüfkraft für die Nanoindentierung liegt in der Regel unterhalb von 15mN.

Zur Messung der reinen Eigenschaften der Beschichtung ohne Beeinflussung durch das Substrat wird eine Faustregel von 10 % der Schichtdicke verwendet. Tiefer gehendere Eindringkurven beinhalten einen Einfluss durch das verwendete Substrat. Bei steigenden Eindringtiefen von über 10 % der Schichtdicke nähern sich die gemessenen Werte für Elastizitätsmodul und Härte sukzessive an die des Substrats an. Die beschriebene Auswertung nach diesem Messverfahren wird nach Oliver & Pharr benannt [Oliver].

Zur einfacheren Variation der Eindringtiefen bei verschiedenen Lasten wird das sogenannte multiple Be- und Entlastungsverfahren, kurz Multiindentierungsverfahren, verwendet. Hierbei werden auf einer festen Stelle segmentweise Be- und Entlastungen vorgenommen. Die lokalen Belastungsmaxima werden dabei kontinuierlich gesteigert. Auf der festen Stelle können so tiefenabhängige Werte des Elastizitätsmoduls und der Härte ermittelt werden. Zusätzlich werden aus statistischen Zwecken auf einem Messfeld verschiedene unbeeinflusste Stellen der Probe ebenfalls angefahren und getestet. Durch Vergleich zwischen Einzelindentierung und Multiindentierungsverfahren haben Schiffmann & Küster nachgewiesen, dass es nur sehr kleine Abweichungen zwischen den ermittelten Werten der beiden Verfahren gibt [Schiffmann]. Zur Kompensation werden längere Haltezeiten zur Verhinderung von Kriecheffekten der Piezoscanner vorgeschlagen [Schiffmann].

Bei den gemessenen Proben der im Text beschriebenen Ausführungsbeispiele wurde mit 10 Multiindents pro Stelle mit bevorzugt maximal 5 mN, weiter bevorzugt kleiner 2 mN noch weiter bevorzugt kleiner 1 mN gemessen. Die Multiindents haben lokale Kraftmaxima, die dann auf 20 % der Kraft reduziert wurden. Diese Entlastungskurven wurden in der Form einer Tangente von 98 bis 40 % ausgewertet.

Es wurden 10 Messpunkte für die Statistik und Homogenität pro Probe getestet. Die Entfernung der Messpunkte betrug 50 µm, um Einflüsse wie beispielsweise plastische Deformationen der zu prüfenden Schicht durch vorherige Messungen zu vermeiden.

Die Schichtdicken der Proben welche zur Bestimmung der Schichthärten herangezogen wurden, betrugen jeweils mehr als 1 µm. Für die Einhalterung der Faustformel für die Eindringtiefe von max. 10 % der Schichtdicke sind die Entlastungskurven bei den Multiindents bis zur maximalen Kraft von maximal 5 mN, weiter bevorzugt kleiner 2 mN noch weiter bevorzugt kleiner 1 mN zulässig für die Auswertung. Bei geringeren Schichtdicken ist auf die zugehörige max. lokale Kraft zu achten, um die 10 % - Regel nicht zu überschreiten.

Die maximale Kraft für die Eindringtiefe und die korrespondierende Entlastungskurve ist also bevorzugt maximal 5 mN, weiter bevorzugt kleiner 2 mN, abhängig von der Schichtdicke von ca. 1000 nm ist sie noch weiter bevorzugt kleiner 1 mN.

### Verwendete Gerätschaften:

Für die Nanoindentierungen des Beispiels (Ausführungsbeispiele, Beispiel 1) wurde ein Universal Material Tester (UMT) mit Nanoindentierungsmodul Nano-Head (NH2) der Fa. CETR (nunmehr unter Fa. Bruker AXS S.A.S.) mit entsprechender Vibrationsdämpfungstechnik (Minus k) in einer thermisch und akkustischen Isolierungskammer eingesetzt.

Referenzen zur Beschreibung der gängigen Lehre:
- [Oliver]: W.C. Oliver et al., J. Mater. Res. Vol. 7, No. 6. (1992), 1564
- [Schiffmann]: K.I. Schiffmann et al., Z. Metallkunde 95, No. 5 (2004), 311

### Ausführungsbeispiele

### Beispiel 1

### Beschichtungsprozess Niederdruckplasma

Die abgeschiedenen Plasmapolymerschichten auf Basis eines anorganischen Matrixgerüsts (bevorzugt siliziumbasiert) haben einen vergleichsweise hohen organischen Charakter, der, im Vergleich zu SiOx-Schichten, eine höheren crack-onset-strain zur Folge hat. Die Plasmaschichten werden bevorzugt im Vakuum bei ca. 10-2 mbar mit Hilfe einer Hochfrequenz-Plasmaentladung (PE-CVD) abgeschieden. Hierbei wird ein siliziumhaltiges Arbeitsgas fragmentiert. Die entstandenen Fragmente schlagen sich als dünne Schicht auf dem Substrat nieder. Um die Dichtigkeit der Schicht zu erhöhen, wird mit einem ionengestützten Verfahren gearbeitet, d.h. die teilweise ionisierten Fragmente werden unter dem Einfluss eines elektrischen Feldes in die wachsende Schicht eingeschossen. Die Verwendung dieser Technologie gewährleistet die Übertragbarkeit der Beschichtung auf die komplexe Spulengeometrie.

### Beschichtungsprozess Niederdruckplasma

- Die Plasmabeschichtung wird im Vakuum mit einem Reaktor der Größe von 360L bei ca. 10⁻² mbar durchgeführt. Eine Aluminiumspule mit 14 Windungen wird auf eine Länge von 18 cm auseinandergezogen und auf zwei Koppelbleche (200 mm x 25 mm x 1 mm) gestellt. Diese Bleche liegen auf einer Isolatorplatte (0,2 mm), die wiederum auf der eigentlichen Plasmaelektrode liegt. Durch diesen Aufbau wird während der Plasmabeschichtung auftretendes Arcing unterbunden. Die Kapazität der Koppelbleche beträgt jeweils ca. 68 pF. Bei der verwendeten Frequenz der Hochfrequenz von 13.56 MHz ergibt sich ein Widerstand pro Koppelblech von 171 Ohm.
- Zu Beginn des Beschichtungsprozesses wird 3 Minuten lang eine Plasmaaktivierung mit Sauerstoff durchgeführt. Dieser Schritt führt zu einer Verbesserung der Schichthaftung.
   Im zweiten Schritt wird eine Primerschicht abgeschieden. Hierzu wird zum Sauerstoff ein Fluss von 5 sccm Hexamethyldisilxan (HMDSO)) in den Reaktor eingelassen. Die Prozesszeit beträgt 1 Minute. Der eigentliche Abscheideprozess der Isolationsbeschichtung wird bei einem HMDSO-Fluss von 20 sccm durchgeführt. Die Prozesszeit liegt bei 2 Stunden. Um die Oberfläche der beschichteten Spule zu hydropilieren, kann abschließend noch eine weitere Plasmaaktivierung mit Sauerstoff durchgeführt werden. Die Plasmaleistung und der Sauerstofffluss sind bei allen Prozessschritten konstant und liegen bei 45 W bzw. 60 sccm.
- Die beschichtete Spule wurde bezüglich der Schichtdicke und der Isolationswirkung charakterisiert. Hierbei ergaben sich folgende Werte:

**Tabelle 1**

| Fläche der Windung (Schichtdicke ca. 4,5 µm) | Außenkante (Schichtdicke ca. 7,0 µm) | Innenkante (Schichtdicke ca. 11 µm) |
|---|---|---|
| 470 V | 610 V | 640 V |
| 470 V | 540 V | 720 V |
| 450 V | 620 V | 670 V |
| **Ø 463,3 V** | **Ø 590,0 V** | **Ø 676,7 V** |

Alternativ kann der Beschichtungsprozess mittels Plasma auch durch das Anlegen einer sogenannten BIAS-Spannung unterstützt werden. Vorteile sind hierbei die Möglichkeit zur Erhöhung der Schichtabscheiderate sowie die Möglichkeit zur Generierung einer dichteren Plasmapolymermatrix.

### Beispiel 2

### Behandlungsprozess Anodisierung + ND-Plasma-Beschichtung

Al-Bleche / Al-Spulen werden nasschemisch gereinigt, gebeizt und 5-60 min in einem Schwefelsäure-basierten Elektrolyten anodisiert. Die nachfolgende Behandlung einer Heißverdichtung von 10 bis 60 Minuten bei 90 °C bis 100 °C ist optional. Die so hergestellten Anodisierschichten auf den Aluminiumspulen weisen eine Schichtdicke von 1 µm bis 25 µm auf. Anschließende Beschichtungsbehandlung nach Schema des Beispiel 1.

### Beispiel 3

### Behandlungsprozess Anodisierung + Füllen der Poren der Anodisierschicht + ND-Plasma-Beschichtung

AI-Bleche werden nasschemisch gereinigt, gebeizt und 10 bis 60 min in einem Schwefelsäure-basierten Elektrolyten anodisiert. Es findet keine Heißverdichtung statt. Die Bleche werden anschließend in einem US-Bad mit HTA-Öl ausgelagert (5, 15, 30min). Abschließend erfolgt eine Wärmebehandlung zur Vernetzung des Öls (7 d bei RT oder 30min bei 100 °C). Anschließende Beschichtungs-behandlung nach Schema des Beispiel 1.

Im Ergebnis kann die Durchschlagsfestigkeit bis zu 20 % im Vergleich zu Beispiel 2 gesteigert werden.

### Beispiel 4

### Auslagerung

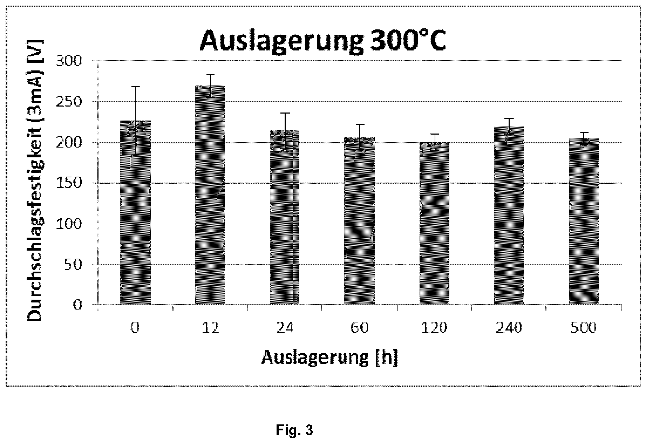

Ausführung der Beschichtung der Spulen erfolgte wie in Beispiel 1 - die anschließende Auslagerung wie in Messbeispiel 4. Die Ergebnisse werden in der Figur 3 abgebildet.

## Patentansprüche

1. Passives elektrisches Bauteil, insbesondere eine Spule, mit einer Zwischenschicht, wobei die Zwischenschicht einen geringeren Wärmeausdehnungskoeffizienten als die Oberfläche des elektrischen Bauteils, die mit der Zwischenschicht bedeckt ist, besitzt, und darauf angeordnet eine plasmapolymere, kohlenstoffhaltige Beschichtung mit einem Kohlenstoffanteil gemessen in einer Tiefe von 80 nm entfernt von der von der Zwischenschicht abgewandten Seite der plasmapolymeren Beschichtung, wobei die plasmapolymere Beschichtung einen Kohlenstoffanteil von 50 bis 100 Atom-%, vorzugsweise 50 bis 90 Atom-% umfasst oder als metallorganische Beschichtung einen Kohlenstoffanteil von 2 bis 50 Atom-% ausgestaltet ist, jeweils gemessen mittels XPS und bezogen auf die mit XPS erfassten Atome; und wobei die plasmapolymere Schicht eine Dicke von 100 nm bis 100 µm besitzt.

2. Passives elektrisches Bauteil mit einer Zwischenschicht nach Anspruch 1, wobei die Zwischenschicht ausgewählt ist aus der Gruppe der keramischen Schichten, bevorzugt auf Basis TiO₂, SiO₂, Al₂O₃, TiₓN_{y} oder BN, weiter bevorzugt eine Eloxalschicht.

3. Passives elektrisches Bauteil mit einer Zwischenschicht nach einem der vorangehenden Ansprüche, wobei die Zwischenschicht ein vernetztes und/oder unvernetztes Öl und/oder vernetztes und/oder unvernetztes Silokonöl enthällt und/oder zwischen der Zwischenschicht und der plasmapolymeren Schicht eine Zone aus vernetztem Öl oder vernetztem Silikonöl vorhanden ist.

4. Passives elektrisches Bauteil mit einer Zwischenschicht nach einem der vorangehenden Ansprüche, wobei die plasmapolymere Beschichtung Silizium umfasst.

5. Passives elektrisches Bauteil mit einer Zwischenschicht nach einem der vorangehenden Ansprüche, wobei die mit der Zwischenschicht bedeckte Oberfläche des Bauteils aus Kupfer, Aluminium oder einer Legierung umfassend Kupfer und/oder Aluminium besteht.

6. Passives elektrisches Bauteil mit einer Zwischenschicht nach einem der vorangehenden Ansprüche, wobei die plasmapolymere Beschichtung,
- eine Rissdehnung von ≥ 2,5 % und/oder
- eine mittels Nanoindentation zu messende Härte im Bereich von 2 bis 6 GPa, vorzugsweise 3,1 bis 6 GPa aufweist.

7. Passives elektrisches Bauteil mit einer Zwischenschicht nach einem der vorangehenden Ansprüche, wobei die plasmapolymere Beschichtung durch Messung mittels XPS gemessen in einer Tiefe von 80 nm entfernt von der von der Zwischenschicht abgewandten Seite der plasmapolymeren Beschichtung bestimmbare Anteile umfasst von 5 bis 40 Atom-%, bevorzugt 20 bis 32 Atom-% Silicium und/oder 30 bis 70 Atom-%, bevorzugt 40 bis 64 Atom-% Sauerstoff aufweist, bezogen auf die Gesamtzahl der in der Beschichtung enthaltenen Kohlenstoff-, Silicium- und Sauerstoffatome.

8. Passives elektrisches Bauteil mit einer Zwischenschicht nach einem der Ansprüche 1 bis 7, wobei die plasmapolymere Schicht eine Dicke von 200 nm bis 50 µm und weiter bevorzugt 500 nm bis 10 µm besitzt.

9. Passives elektrisches Bauteil mit einer Zwischenschicht nach einem der Ansprüche 1 bis 8, wobei die Zwischenschicht und die plasmapolymere Schicht gemeinsam eine Durchschlagsfestigkeit gemessen nach DIN EN 60243-1 und DIN EN 60243-2 von ≥ 100 V gemessen bis zu einem maximalen Stromfluss von 3 mA besitzt.

10. Passives elektrisches Bauteil mit einer Zwischenschicht nach einem der Ansprüche 1 bis 9, wobei das Bauteil nach einer Auslagerung bei 300 °C für 500 Stunden in einem Umluftofen bei trockener Umluft und danach folgender Abkühlung auf 20 °C innerhalb einer Stunde wenigstens 80 % der Durchschlagsfestigkeit vor der Auslagerung besitzt.

11. Passives elektrisches Bauteil mit einer Zwischenschicht nach einem der Ansprüche 1 bis 10, wobei das elektrische Bauteil im Bereich der plasmapolymeren Schicht gegenüber einer 1 mol/L NaOH-Lösung für eine Dauer von 20 Minuten bei Raumtemperatur keinen optisch feststellbaren Ätzangriff aufweist.

12. Verwendung einer plasmapolymeren Beschichtung, wie in einem der vorangehenden Ansprüche 1, 4 und 6 bis 8 definiert, zur Verbesserung der thermischen und/oder mechanischen Belastbarkeit und/oder der medialen Beständigkeit einer Zwischenschicht, wie in einem der vorangehenden Ansprüche 1 bis 3 definiert, auf einem passiven elektrischen Bauteil, wie in einem der vorangehenden Ansprüche 1 und 5 definiert, insbesondere durch Verhinderung des Entstehens durchgängiger Mikrorisse.

13. Verwendung einer plasmapolymeren Beschichtung, wie in einem der Ansprüche 1, 4 und 6 bis 8 definiert zur Wiederherstellung der Isolierwirkung einer wie in einem der Ansprüche 1 bis 3 definierten Zwischenschicht auf einem passiven elektrischen Bauteil, wie in einem der Ansprüche 1 und 5 definiert.

14. Verfahren zu Herstellung eines passiven elektrischen Bauteils, wie in einem der Ansprüche 1 bis 11 definiert, mit einer Zwischenschicht und darauf angeordneten plasmapolymeren Beschichtung, umfassend die Schritte:
a) Bereitstellen eines passiven elektrischen Bauteils wie in einem der Ansprüche 1 und 5 definiert, als Substrat,
b) Anordnen einer Zwischenschicht wie einem der Ansprüche 1 bis 3 definiert auf dem Substrat, bevorzugt mittels eines nasschemischen Verfahrens,
c) Abscheiden einer plasmapolymeren Beschichtung wie einem der Ansprüche 1, 4 und 6 bis 8 definiert auf der Zwischenschicht.

15. Verfahren nach Anspruch 14, wobei Schritt c) in einem Hochfrequenzplasmapolymerisationsreaktor unter Niederdruck durchgeführt wird und das Substrat als Kathode geschaltet ist.

## Claims

1. Passive electrical component, especially a coil, having an interlayer, wherein the interlayer has a lower coefficient of thermal expansion than the surface of the electrical component covered with the interlayer, and disposed atop that a plasma-polymeric carbon-containing coating having a carbon content measured at a depth of 80 nm away from the side of the plasma-polymeric coating remote from the interlayer, wherein the plasma-polymeric coating comprises a carbon content of 50 to 100 atom%, preferably 50 to 90 atom%, or is configured as an organometallic coating a carbon content of 2 to 50 atom%, in each case measured by means of XPS and based on the atoms detected by XPS, and wherein the plasma-polymeric layer has a thickness of 100 nm to 100 µm.

2. Passive electrical component having an interlayer according to Claim 1, wherein the interlayer is selected from the group of the ceramic layers, preferably based on TiO₂, SiO₂, Al₂O₃, TiₓN_{y} or BN, further preferably an eloxal layer.

3. Passive electrical component having an interlayer according to either of the preceding claims, wherein the interlayer comprises a crosslinked and/or uncrosslinked oil and/or crosslinked and/or uncrosslinked silicone oil and/or there is a zone of crosslinked oil or crosslinked silicone oil present between the interlayer and the plasma-polymeric layer.

4. Passive electrical component having an interlayer according to any of the preceding claims, wherein the plasma-polymeric coating comprises silicon.

5. Passive electrical component having an interlayer according to any of the preceding claims, wherein the surface of the component covered with the interlayer consists of copper, aluminium or an alloy comprising copper and/or aluminium.

6. Passive electrical component having an interlayer according to any of the preceding claims, wherein the plasma-polymeric coating has
- an extension before cracking of ≥ 2.5% and/or
- a hardness to be measured by means of nanoindentation in the range from 2 to 6 GPa, preferably 3.1 to 6 GPa.

7. Passive electrical component having an interlayer according to any of the preceding claims, wherein the plasma-polymeric coating comprises proportions, determinable by measurement by means of XPS measured at a depth of 80 nm away from the side of the plasma-polymeric coating remote from the interlayer, of 5 to 40 atom%, preferably 20 to 32 atom%, of silicon and/or 30 to 70 atom%, preferably 40 to 64 atom%, of oxygen, based on the total number of the carbon, silicon and oxygen atoms present in the coating.

8. Passive electrical component having an interlayer according to any of Claims 1 to 7, wherein the plasma-polymeric layer has a thickness of 200 nm to 50 µm and further preferably 500 nm to 10 µm.

9. Passive electrical component having an interlayer according to any of Claims 1 to 8, wherein the interlayer and the plasma-polymeric layer together have a breakdown resistance measured to DIN EN 60243-1 and DIN EN 60243-2 of ≥ 100 V measured up to a maximum current flow of 3 mA.

10. Passive electrical component having an interlayer according to any of Claims 1 to 9, wherein the component after ageing at 300°C for 500 hours in an air circulation oven under dry circulating air followed by cooling to 20°C within one hour has at least 80% of the breakdown resistance prior to the ageing.

11. Passive electrical component having an interlayer according to any of Claims 1 to 10, wherein the electrical component does not have any visually detectable etch attack in the region of the plasma-polymeric layer on exposure to a 1 mol/L NaOH solution for a duration of 20 minutes at room temperature.

12. Use of a plasma-polymeric coating as defined in any of preceding Claims 1, 4 and 6 to 8, for improving the thermal and/or mechanical durability and/or media stability of an interlayer as defined in any of preceding Claims 1 to 3 on a passive electrical component, as defined in one of preceding Claims 1 and 5, especially by prevention of the formation of continuous microcracks.

13. Use of a plasma-polymeric coating as defined in any of Claims 1, 4 and 6 to 8 for restoring the insulating effect of an interlayer as defined in any of Claims 1 to 3 on a passive electrical component, as defined in one of Claims 1 and 5.

14. Process for producing a passive electrical component as defined in any of Claims 1 to 11, having an interlayer and plasma-polymeric coating disposed thereon, comprising the steps of:
a) providing a passive electrical component as defined in one of Claims 1 and 5 as a substrate,
b) disposing an interlayer as defined in any of Claims 1 to 3 on the substrate, preferably by means of a wet-chemical process,
c) depositing a plasma-polymeric coating as defined in any of Claims 1, 4 and 6 to 8 atop the interlayer.

15. Process according to Claim 14, wherein step c) is conducted in a high-frequency plasma polymerization reactor under low pressure and the substrate is connected as the cathode.

## Revendications

1. Pièce électrique passive, en particulier une bobine, avec une couche intermédiaire, dans laquelle la couche intermédiaire possède un coefficient de dilatation thermique inférieur à celui de la surface de la pièce électrique qui est recouverte de la couche intermédiaire, et agencé dessus, un revêtement polymère plasmatique, contenant du carbone avec une part de carbone mesurée à une profondeur de 80 nm distante du côté éloigné de la couche intermédiaire du revêtement polymère plasmatique, dans laquelle le revêtement polymère plasmatique comporte une part de carbone de 50 à 100 % en atome, de préférence de 50 à 90 % en atome ou est configuré comme revêtement métallo-organique avec une part de carbone de 2 à 50 % en atome, respectivement mesurée par spectroscopie XPS et par rapport aux atomes détectés par spectroscopie XPS ; et dans laquelle la couche polymère plasmatique possède une épaisseur de 100 nm à 100 µm.

2. Pièce électrique passive avec une couche intermédiaire selon la revendication 1, dans laquelle la couche intermédiaire est sélectionnée à partir du groupe des couches céramiques, de préférence à base de TiO₂, SiO₂, Al₂O₃, TiₓN_{y} ou BN, de manière davantage préférée une couche anodisée.

3. Pièce électrique passive avec une couche intermédiaire selon l'une quelconque des revendications précédentes, dans laquelle la couche intermédiaire contient une huile réticulée et/ou non réticulée et/ou une huile de silicone réticulée et/ou non réticulée et/ou une zone d'huile réticulée ou d'huile de silicone réticulée est présente entre la couche intermédiaire et la couche polymère plasmatique.

4. Pièce électrique passive avec une couche intermédiaire selon l'une quelconque des revendications précédentes, dans laquelle le revêtement polymère plasmatique comporte du silicium.

5. Pièce électrique passive avec une couche intermédiaire selon l'une quelconque des revendications précédentes, dans laquelle la surface recouverte de la couche intermédiaire de la pièce se compose de cuivre, d'aluminium ou d'un alliage comprenant du cuivre et/ou de l'aluminium.

6. Pièce électrique passive avec une couche intermédiaire selon l'une quelconque des revendications précédentes, dans laquelle le revêtement polymère plasmatique présente
- un allongement à la rupture ≥ 2,5 % et/ou
- une dureté à mesurer par nanoindentation dans la plage de 2 à 6 GPa, de préférence de 3,1 à 6 GPa.

7. Pièce électrique passive avec une couche intermédiaire selon l'une quelconque des revendications précédentes, dans laquelle le revêtement polymère plasmatique comporte des parts pouvant être déterminées par mesure par spectroscopie XPS mesurée à une profondeur de 80 nm distante du côté éloigné de la couche intermédiaire du revêtement polymère plasmatique de 5 à 40 % en atome, de préférence de 20 à 32 % en atome de silicium et/ou de 30 à 70 % en atome, de préférence de 40 à 64 % en atome d'oxygène, par rapport au nombre entier d'atomes de carbone, de silicium et d'oxygène contenus dans le revêtement.

8. Pièce électrique passive avec une couche intermédiaire selon l'une quelconque des revendications 1 à 7, dans laquelle la couche polymère plasmatique possède une épaisseur de 200 nm à 50 µm et de manière davantage préférée de 500 nm à 10 µm.

9. Pièce électrique passive avec une couche intermédiaire selon l'une quelconque des revendications 1 à 8, dans laquelle la couche intermédiaire et la couche polymère plasmatique possèdent ensemble une rigidité diélectrique mesurée selon DIN EN 60243-1 et DIN EN 60243-2 ≥ 100 V mesurée jusqu'à un flux de courant maximal de 3 mA.

10. Pièce électrique passive avec une couche intermédiaire selon l'une quelconque des revendications 1 à 9, dans laquelle la pièce possède après un durcissement par précipitation à 300 °C pendant 500 heures dans une étuve à circulation d'air en cas d'air de circulation sec et ensuite de refroidissement consécutif à 20 °C en une heure au moins 80 % de la rigidité diélectrique avant le durcissement par précipitation.

11. Pièce électrique passive avec une couche intermédiaire selon l'une quelconque des revendications 1 à 10, dans laquelle la pièce électrique ne présente aucune attaque de corrosion constatable optiquement dans la zone de la couche polymère plasmatique par rapport à une solution de 1 mole/L de NaOH pour une durée de 20 minutes à température ambiante.

12. Utilisation d'un revêtement polymère plasmatique comme défini dans l'une des revendications précédentes 1, 4 et 6 à 8, pour l'amélioration de la capacité de charge thermique et/ou mécanique et/ou de la résistance médiale d'une couche intermédiaire, comme définie dans l'une des revendications précédentes 1 à 3, sur une pièce électrique passive, comme définie dans l'une des revendications précédentes 1 et 5, en particulier par empêchement de l'apparition de microfissures continues.

13. Utilisation d'un revêtement polymère plasmatique, comme défini dans l'une des revendications précédentes 1, 4 et 6 à 8 pour le rétablissement de l'action isolante d'une couche intermédiaire comme définie dans l'une des revendications 1 à 3 sur une pièce électrique passive, comme définie dans l'une des revendications 1 et 5.

14. Procédé de fabrication d'une pièce électrique passive, comme définie dans l'une des revendications 1 à 11, avec une couche intermédiaire et un revêtement polymère plasmatique agencé dessus, comprenant les étapes consistant à :
a) fournir une pièce électrique passive comme définie dans l'une des revendications 1 et 5, comme substrat,
b) agencer une couche intermédiaire, comme définie dans l'une des revendications 1 à 3 sur le substrat, de préférence au moyen d'un procédé chimique en milieu humide,
c) séparer un revêtement polymère plasmatique comme défini dans l'une des revendications 1, 4 et 6 à 8 sur la couche intermédiaire.

15. Procédé selon la revendication 14, dans lequel l'étape c) est réalisée dans un réacteur de polymérisation au plasma à haute fréquence à basse pression et le substrat est monté comme cathode.
